# EUROPÄISCHE PATENTANMELDUNG

(11) **EP 2 012 513 A2**
(43) Veröffentlichungstag der Anmeldung: **07.01.2009**
(21) Anmeldenummer: 08166908.7
(22) Anmeldetag: 17.09.2003
(51) Int. Cl.: H04M 3/18, H01C 1/02

(54) **Elektrische Baugruppe und deren Verwendung**

(30) Priorität: 17.09.2002 DE 10243113
(62) Teilanmeldung aus: 03797180.1
(71) Anmelder: Epcos AG, 81669 München (DE)
(72) Erfinder: Die Erfindernennung liegt noch nicht vor
(74) Vertreter: Epping - Hermann - Fischer

(57) **Zusammenfassung**

Die Erfindung betrifft eine elektrische Baugruppe mit einem Gehäuse (1), enthaltend wenigstens zwei gleichartige elektrische Bauelemente (21, 22), die in Bezug auf eine Kenngröße aneinander angepaßt sind, und mit Anschlüssen (311, 312, 321, 322) zur separaten Kontaktierung jedes einzelnen Bauelements (21, 22). Die Baugruppe kann vorteilhaft bei Telekomanwendungen verwendet werden, wo zwei Telefonleitungen mit Thermistoren derselben Widerstandsklasse bestückt werden müssen.

## Beschreibung

Die Erfindung betrifft eine elektrische Baugruppe mit zwei elektrischen Bauelementen. Es sind ferner Anschlüsse zur Kontaktierung der Bauelemente vorgesehen. Ferner betrifft die Erfindung die Verwendung der Baugruppe.

Es ist bekannt, Thermistoren als Fehlerschutzelemente bei der Absicherung von Telefonleitungen zu verwenden. Diese Thermistoren, auch bekannt unter dem Namen PTC (Positive Temperature Coefficient), sind Bauelemente, deren Widerstand einen positiven Temperaturkoeffizienten aufweisen. PTC erhöhen bei elektrischer Belastung den Widerstand, wodurch diese hohe Belastung dann abgeblockt werden kann.

Der Thermistor wird benötigt zum Schutz der Telefonleitung vor unerlaubten Belastungen, wie beispielsweise Blitzen, erhöhten Spannungen, Kontakt der Telefonleitungen mit Energieleitungen, Schaltüberspannungen, induzierte Spannungen oder dergleichen. Die Thermistoren werden üblicherweise in einer Telekommunikations-Verteilerstation eingebaut.

In der Anwendung bei Telefonleitungen werden die beiden Leitungen eines Telefonanschlusses jeweils separat geschützt, daher sind zwei Thermistoren notwendig, um den gewünschten Schutz zu gewährleisten. Um ein Übersprechen zwischen den Telefonleitungen und damit ungewünschte Störungen zu vermeiden, muß ein Telefonanschluß symmetrisch aufgebaut werden. Dies kann erreicht werden, indem die Widerstandswerte der beiden für die einzelnen Telefonleitungen verwendeten Thermistoren aneinander angepaßt sind. Zur Anpassung wird üblicherweise der elektrische Widerstand der Thermistoren bei einer Temperatur von 25° C verwendet.

Da es bei der Herstellung der Thermistoren eine gewisse Streubreite in den Widerstandswerten bei 25° C gibt, werden die Thermistoren nach der Herstellung in sogenannte Widerstandsklassen einsortiert und ausgeliefert. Innerhalb einer Widerstandsklasse darf die Abweichung zweier Widerstände einen vom Anwender spezifizierten Wert nicht übersteigen. Ein solcher Wert kann beispielsweise 1 Ω betragen.

Es ist darüber hinaus bekannt, zwei angepaßte Thermistoren getrennt auf einer Platine mit der jeweiligen zum Telefonanschluß gehörenden Telefonleitung zu verbinden. Diese Aufgabe wird normalerweise von Bestückungsautomaten übernommen. Um den geforderten Widerstandsabgleich zwischen den beiden Telefonleitungen zu gewährleisten, sind Sonderprogramme bei den Bestückungsautomaten erforderlich, die dafür sorgen, daß jeweils nur abgeglichene Fehlerschutzelemente nebeneinander und mithin zu einem Telefonanschluß gehörig auf der Platine platziert werden.

Beim Wechsel der Gurte, in denen die Fehlerschutzelemente üblicherweise den Bestückungsautomaten zugeführt werden, kann es vorkommen, daß nicht aufeinander abgeglichene Thermistoren nebeneinander platziert werden. Diese Fehlerquelle ist nachteilig, da es die nachträgliche Überprüfung und gegebenenfalls auch Austausch von Thermistoren erforderlich macht.

Zusätzlich müssen bei jeder Nachbearbeitung der Platine jeweils beide aufeinander abgeglichene Fehlerschutzelemente ausgetauscht werden, um auch in Zukunft den gewünschten Widerstandsabgleich zu gewährleisten.

Es ist Aufgabe der vorliegenden Erfindung, eine Baugruppe anzugeben, die zur Absicherung von Telefonleitungen geeignet ist und bei der die Gefahr einer fehlerhaften Zuordnung von Fehlerschutzelementen reduziert ist.

Diese Aufgabe wird gelöst durch eine Baugruppe nach Patentanspruch 1. Vorteilhafte Ausgestaltungen der Baugruppe sowie eine Verwendung der Baugruppe sind den weiteren Patentansprüchen zu entnehmen.

Es wird eine elektrische Baugruppe angegeben, die ein Gehäuse aufweist. Das Gehäuse enthält wenigstens zwei gleichartige elektrische Bauelemente. Die elektrischen Bauelemente sind in Bezug auf eine Kenngröße aneinander angepaßt. Ferner weist die Baugruppe Anschlüsse auf, die zur separaten Kontaktierung jedes einzelnen Bauelements geeignet ist.

Die Baugruppe hat den Vorteil, daß sie zwei aneinander angepaßte elektrische Bauelemente enthält, wodurch es möglich ist, Schutzelemente zum Schutz von Telefonleitungen in einem Arbeitsschritt so auf eine Platine zu montieren, daß jede der beiden Telefonleitungen mit einem elektrischen Bauelement der Baugruppe verbunden ist. Dadurch ist gewährleistet, daß immer nur aneinander angepaßte elektrische Bauelemente an die beiden Telefonleitungen eines Telefonanschlusses kontaktiert werden.

Die elektrische Baugruppe hat desweiteren den Vorteil, daß die Montage der beiden elektrischen Bauelemente in einem einzigen Schritt erfolgen kann, was die Kosten für die Herstellung und gesicherten Telefonleitungen vorteilhafterweise senkt.

Desweiteren hat die elektrische Baugruppe gegenüber zwei einzelnen Schutzelementen den Vorteil, daß der Platzbedarf auf der Platine, auf die die elektrische Baugruppe zu montieren ist, sinkt.

Es ist dementsprechend vorteilhaft, wenn die beiden elektrischen Bauelemente Thermistoren sind, deren Widerstände bei einer Temperatur aneinander angepaßt sind.

Es ist darüber hinaus vorteilhaft, wenn die Widerstände bei einer Temperatur von 25° C aneinander angepaßt sind.

Es wird an dieser Stelle darauf hingewiesen, daß unter einem Thermistor ein elektrisches Bauelement zu verstehen ist, dessen elektrischer Widerstand einen positiven Temperaturkoeffizienten (Positive Temperature Coefficient = PTC) aufweist. Ferner weist der Thermistor eine Widerstands-Temperatur-Kennlinie auf, die so gestaltet ist, daß sich der Widerstand des Thermistors mit der Temperatur erhöht. Bei Belastung erhöht sich die Temperatur des Thermistors, wodurch dann sein Widerstand ansteigt.

Es ist darüber hinaus vorteilhaft, wenn die Widerstände der beiden elektrischen Bauelemente um maximal 1 Ω voneinander abweichen. In diesem Fall ist gewährleistet, daß die beiden Thermistoren in der Baugruppe zu ein und derselben Widerstandsklasse gehören und somit für die Montage auf einer Platine und zur Kontaktierung mit Telefonleitungen, die zu ein und demselben Telefonanschluß gehören, geeignet ist.

In einer Ausführungsform der Baugruppe ist die Oberseite des Gehäuses so gestaltet, daß es mit einer Kamera seitenrichtig erkennbar ist. Dies kann beispielsweise dadurch gewährleistet sein, daß die Oberseite eine geometrische Form aufweist, die nicht völlig symmetrisch ist und die es erlaubt, wenigstens zwei unterschiedliche Seitenflächen der Baugruppe voneinander zu unterscheiden. Beispielsweise kommt es in Frage, die Oberseite des Gehäuses in Form eines Rechtecks auszuführen.

Darüber hinaus ist es vorteilhaft, wenn die Baugruppe so gestaltet ist, daß das Gehäuse zumindest teilweise als Berührschutz ausgebildet ist.

Ein Gehäuse, das als Berührschutz funktioniert, erhält man beispielsweise dadurch, indem wenigstens eine Seitenfläche des Gehäuses geschlossen ist. Desweiteren ist es auch vorteilhaft, wenn der Berührschutz dadurch verbessert wird, daß zwei Seitenflächen des Gehäuses geschlossen sind. Diese beiden Seitenflächen können beispielsweise die Oberseite des Gehäuses sowie eine weitere Seitenfläche sein. Die Oberseite des Gehäuses kann dann in einer vorteilhaften Ausführungsform der Baugruppe gleichzeitig als Berührschutz und als Justiermarke für eine Kamera verwendet werden.

Kameras werden üblicherweise dort verwendet, wo Platinen von Bestückungsautomaten mit Bauelementen oder Baugruppen bestückt werden. Die Kamera erkennt das beispielsweise von einem Transportgurt an den Bestückungsautomaten herangeführte Bauteil. Sie kann eine Baugruppe mit Justiermarke lagerichtig erkennen, wodurch gewährleistet ist, daß der Bestückungsautomat das Bauelement in der richtigen Orientierung greift und auf die Platine setzen kann.

In einer weiteren Ausführungsform der Baugruppe sind die Anschlüsse auf einer Seite, vorzugsweise der Unterseite, des Gehäuses angeordnet. Die Anordnung der Anschlüsse ist dabei so gewählt, daß die Baugruppe verdrehsicher auf eine Platine montiert werden kann. Durch eine solche geeignete Ausgestaltung der Anschlüsse kann dafür gesorgt werden, daß die Gefahr von Bestückungsfehlern weiter reduziert wird.

In einer anderen Ausführungsform der Baugruppe kann zwischen den Bauelementen als Überschlagsschutz eine Trennwand vorgesehen sein, die aus isolierendem Material besteht. Durch eine solche Trennwand können elektrische Überschläge zwischen den beiden elektrischen Bauelementen teilweise oder ganz verhindert werden.

Darüber hinaus ist es vorteilhaft, wenn das Gehäuse aus einem Material besteht, das nur schwer entflammbar ist. Ein schwer entflammbares Gehäuse könnte beispielsweise aus dem Material LCP (Liquid Crystal Polymer) bestehen, welches der Brandschutznorm UL94-V0 genügt.

Desweiteren ist es vorteilhaft, wenn die Anschlüsse so ausgebildet sind, daß die Baugruppe oberflächenmontierbar ist. Daraus ergibt sich der Vorteil, daß die Montage der Baugruppe auf einer Platine mittels der leistungsfähigen und wirtschaftlichen Oberflächenmontagetechnik montiert werden kann, wodurch die Kosten für die Herstellung von geschützten Telefonleitungen weiter gesenkt werden können.

Es wird darüber hinaus die Verwendung der Baugruppe angegeben, wobei die Verwendung in einem Bestücken einer Platine besteht. Die in der Baugruppe enthaltenen elektrischen Bauelemente sind dabei jeweils mit einer Leitung zur Übertragung von Daten verbunden. Wenigstens zwei der Leitungen sind ein und demselben Datenendgerät zugeordnet.

Die beschriebene Verwendung hat den Vorteil, daß es damit gelingt, zwei Telefonleitungen mit aneinander angepaßten elektrischen Bauelementen zu verbinden. Dadurch wird die Fehlerquote beim Bestücken von Platinen zum Ausrüsten von Telefonleitungen mit Elementen vermindert. Die Baugruppe kann neben den beiden Bauelementen, die zum Schutz von zwei Telefonleitungen erforderlich sind, noch weitere Bauelemente enthalten.

Im folgenden wird die Erfindung anhand von Ausführungsbeispielen und den dazugehörigen Figuren näher erläutert.
- Figur 1: zeigt beispielhaft die Baugruppe in einer Seitenan- sicht.
- Figur 2: zeigt eine Ansicht von oben auf die Baugruppe von Figur 1.
- Figur 3: zeigt eine Seitenansicht der Baugruppe von Figur 1.
- Figur 4: zeigt eine Ansicht von unten der Baugruppe von Fi- gur 1.
- Figur 5: zeigt eine Platine, die mit der Baugruppe aus Figur 1 bestückt ist.

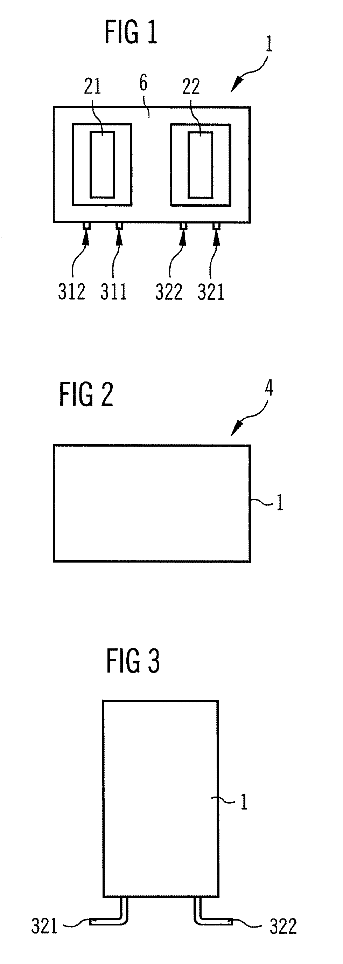

Figur 1 zeigt eine Baugruppe mit einem Gehäuse 1. Das Gehäuse 1 weist zwei Hohlräume auf, wobei in jedem Hohlraum ein elektrisches Bauelement 21, 22 angeordnet ist. Bei den elektrischen Bauelementen 21, 22 handelt es sich um Thermistoren. Die beiden elektrischen Bauelemente 21, 22 sind durch eine Trennwand 6 voneinander getrennt. Durch die Trennwand 6 wird ein Überschlagschutz zum Schutz vor Überschlägen zwischen den beiden elektrischen Bauelementen 21, 22 realisiert.

Auf der Unterseite des Gehäuses 1 sind Anschlüsse 311, 312, 321, 322 vorgesehen, die in Figur 1 lediglich schematisch angedeutet sind. Es ist dafür gesorgt, daß die Anschlüsse 311, 312, 321, 322 so ausgebildet sind, daß jedes der elektrischen Bauelemente 21, 22 separat kontaktiert werden kann. Dies erreicht man beispielsweise, indem die beiden Anschlüsse 311, 312 dem elektrischen Bauelement 21 und die beiden Anschlüsse 321, 322 dem elektrischen Bauelement 22 zugeordnet sind. Im einfachsten Fall sind jeweils zwei Anschlüsse 311, 312; 321, 322 mit den Außenkontakten jeweils eines Bauelements 21, 22 kontaktiert.

Figur 2 zeigt eine Ansicht von oben auf das Bauelement aus Figur 1. Zu sehen ist, daß das Gehäuse 1 auf der Oberseite die Kontur eines Rechtecks 4 ausbildet. Ferner ist zu sehen, daß das Gehäuse 1 auf der Oberseite der Baugruppe geschlossen ist. Indem die Oberseite des Gehäuses 1 die Form eines Rechtecks 4 aufweist, kann es von einer Kamera lagerichtig erkannt werden. Ein Rechteck hat nämlich die Eigenschaft, daß die Seiten nicht alle gleich lang sind. Vielmehr gibt es kurze Seiten und längere Seiten. Aufgrund der unterschiedlichen Seitenlänge kann die Lage des Bauelements von einer Kamera erkannt werden.

Darüber hinaus ist das Gehäuse 1 auf der Oberseite geschlossen. Dadurch ergibt sich ein Berührschutz von oben.

Es ist darüber hinaus vorteilhaft, wenn die obere Fläche des Gehäuses 1 eine definierte ebene Angriffsfläche für die Saugvorrichtung eines Bestückautomaten enthält. Dadurch kann das Verfahren zum Bestücken einer Platine mit der elektrischen Baugruppe vereinfacht werden. Eine geeignete Angriffsfläche erhält man bei der Oberseite gemäß Figur 2. Der ebene Anteil an der Gesamtfläche der Oberseite kann aber je nach Saugvorrichtung auch kleiner gewählt sein.

Figur 3 zeigt die Baugruppe in Seitenansicht, wobei neben dem Gehäuse 1 und einer weiteren geschlossenen Seite des Gehäuses 1 noch zwei Anschlüsse 321, 322 zu erkennen sind. Die beiden Anschlüsse 321, 322 sind auf der Unterseite des Gehäuses 1 herausgeführt und nach einem kurzen Streckenabschnitt nach außen so abgebogen, daß eine Oberflächenmontage der beiden Anschlüsse auf einer Platine ermöglicht wird. Insbesondere liegen die beiden abgebogenen Abschnitte der Anschlüsse 321, 322 näherungsweise in einer Ebene. Die Anschlüsse 311, 312 können analoger Art und Weise gebildet sein, wobei auch die Anschlüsse 311, 312 nach außen oder nach innen abgebogene Abschnitte aufweisen, und wobei die abgebogenen Abschnitte aller Anschlüsse 311, 312, 321, 322 näherungsweise in einer Ebene liegen, um die Oberflächenmontierbarkeit des Bauelements zu gewährleisten.

Die Anschlüsse können beispielsweise aus Kupfer bestehen. Das Gehäuse kann beispielsweise aus Kunststoff bestehen.

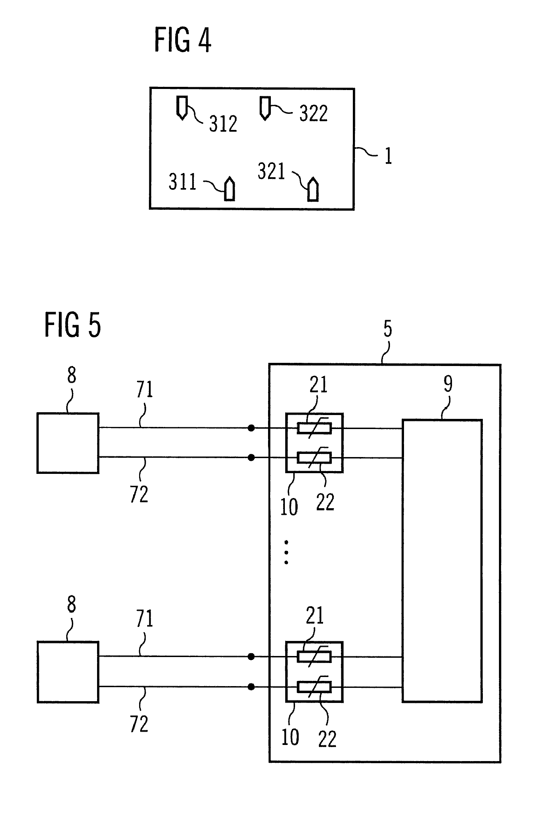

Figur 4 zeigt eine Ansicht von unten auf die Baugruppe, wo die zu Figur 3 bereits beschriebene Ausbildung der Anschlüsse 311, 312, 321, 322 näher beschrieben ist. Es ist in Figur 4 neben der Unterseite des Gehäuses 1 eine bestimmte Anordnung der Anschlüsse 311, 312, 321, 322 zu erkennen. Die Anschlüsse 311, 312, 321, 322 sind so angeordnet, daß das Bauteil verdrehsicher auf der Platine montiert werden kann. Beispielsweise ist es bei entsprechender Gestaltung der Kontaktflächen auf der Platine nicht möglich, die Baugruppe so zu montieren, daß die Unterseite der Baugruppe um 90° in positive oder in negative Richtung gegenüber der in Figur 4 gezeigten und lagerichtigen Position festgelötet werden kann.

Figur 5 zeigt eine Platine 5, auf der eine Zentraleinheit 9 angeordnet ist. Als Platine 5 kann beispielsweise eine sogenannte Linecard verwendet werden, wie sie typischerweise bei Telekomanwendungen zum Einsatz kommt. Dabei sind mehrere Linecards in einer Datenschnittstelle, zum Beispiel einem Wählamt, vereinigt und untereinander verschaltet. Jede Linecard trägt eine Zentraleinheit 9. Eine solche Zentraleinheit 9 kann beispielsweise eine Schaltlogik sein, die verschiedene Telefonanschlüsse miteinander verschaltet.

Mit der Platine 5 sind Datenendgeräte 8 über Leitungen 71, 72 verbunden. Dabei gehört üblicherweise zu jedem Datenendgerät 8 ein Paar von Leitungen 71, 72. Als Datenendgerät 8 kommt beispielsweise ein privater Telefonanschluß in Betracht. Ferner ist zwischen jeder Verbindung eines Datenendgerätes 8 und der Zentraleinheit 9 eine Schutzbeschaltung vorgesehen, die das Datenendgerät 8, wie bereits weiter oben diskutiert, vor Blitzeinschlag, Überströmen und so weiter schützt. Die Schutzbeschaltung kann Gasüberspannungsableiter, Zenerdioden oder auch weitere geeignete Bauelemente umfassen. Sie umfaßt darüber hinaus insbesondere die in den Figuren 1 bis 4 beschriebene Baugruppe und zwar in mehrfacher Ausführung, so daß für jedes Datenendgerät 8 eine solche Baugruppe 10 zur Verfügung steht.

Jede Baugruppe 10 enthält ein Paar von elektrischen Bauelementen 21, 22, welches beispielsweise PTC-Widerstände sind. Dabei ist pro Baugruppe 10 jedes elektrische Bauelement 21, 22 in Reihe zu jeweils einer Leitung 71, 72, welche zum entsprechenden Datenendgerät 8 führt, geschaltet. Die Baugruppe 10 kann beispielsweise durch Oberflächenmontage auf der Platine 5 festgelötet sein.

Die Verwendung der hier beschriebenen Baugruppe 10 zur Montage auf Platinen 5 mit Datenleitungen hat den Vorteil, daß zwei jeweils zusammengehörende Leitungen 71, 72 in einem einzigen Montageschritt mit aneinander angepaßten elektrischen Bauelementen 21, 22 verbunden werden können. Dadurch können Bestückungsfehler, das heißt, insbesondere Fehler bei der Anpassung der zu den Leitungen 71, 72 gehörenden elektrischen Bauelemente 21, 22 mit großer Wahrscheinlichkeit ausgeschlossen werden.

Die Platine 5 beziehungsweise die Linecard kann anstelle der Datenendgeräte 8 auch mit anderen Linecards oder Verteilern verbunden sein.

### Bezugszeichenliste

- 1: Gehäuse
- 21, 22: elektrisches Bauelement
- 311, 312, 321, 322: Anschluß
- 4: Rechteck
- 5: Platine
- 6: Trennwand
- 71, 72: Leitung
- 8: Datenendgerät
- 9: Zentraleinheit
- 10: Baugruppe

## Patentansprüche

1. Elektrische Baugruppe
- mit einem Gehäuse (1), enthaltend wenigstens zwei gleichartige elektrische Bauelemente (21, 22), die in Bezug auf wenigstens eine Kenngröße aneinander angepaßt sind,
- und mit Anschlüssen (311, 312, 321, 322) zur separaten Kontaktierung jedes einzelnen Bauelements (21, 22).

2. Baugruppe nach Anspruch 1,
bei der die Bauelemente (21, 22) Thermistoren sind, deren Widerstände bei einer Temperatur aneinander angepaßt sind.

3. Baugruppe nach Anspruch 2,
bei der die Widerstände bei 25° C aneinander angepaßt sind.

4. Baugruppe nach Anspruch 3,
bei der die Widerstände, gemessen bei 25° C, der Bauelemente (21, 22) um maximal 1 Ω voneinander abweichen.

5. Baugruppe nach einem der Ansprüche 1 bis 4,
bei der das Gehäuse (1) auf der Oberseite so gestaltet ist, daß es mit einer Kamera seitenrichtig erkennbar ist.

6. Baugruppe nach Anspruch 5,
bei der die Oberseite des Gehäuses (1) durch ein geschlossenes Rechteck (4) gebildet ist.

7. Baugruppe nach einem der Ansprüche 1 bis 6,
- bei der die Anschlüsse (311, 312, 321, 322) auf der Unterseite des Gehäuses (1) angeordnet sind,
- und bei der die Anordnung der Anschlüsse (311, 312, 321, 322) so gewählt ist, daß die Baugruppe verdrehsicher auf eine Platine (5) montiert werden kann.

8. Baugruppe nach einem der Ansprüche 1 bis 7,
bei der das Gehäuse (1) als Berührschutz gestaltet ist.

9. Baugruppe nach einem der Ansprüche 1 bis 8,
bei der zwischen den Bauelementen (21, 22) als Überschlagschutz eine Trennwand (6) aus elektrisch isolierendem Material vorgesehen ist.

10. Baugruppe nach einem der Ansprüche 1 bis 9,
bei dem wenigstens eine Seite des Gehäuses (1) geschlossen ist.

11. Baugruppe nach einem der Ansprüche 1 bis 10,
bei der das Gehäuse (1) aus einem Material besteht, das nur schwer entflammbar ist.

12. Baugruppe nach einem der Ansprüche 1 bis 11,
bei der die Anschlüsse (311, 312, 321, 322) so ausgebildet sind, daß die Baugruppe oberflächenmontierbar ist.

13. Verwendung der Baugruppe nach einem der Ansprüche 1 bis 12,
zur Bestückung einer Platine (5), wobei die elektrischen Bauelemente (21, 22) jeweils mit einer Leitung (71, 72) zur Übertragung von Daten verbunden werden und wobei die beiden Leitungen (71, 72) ein und demselben Datenendgerät (8) zugeordnet sind.

14. Baugruppe nach einem der Ansprüche 1 bis 12,
bei der die Oberseite des Gehäuses (1) eine ebene Fläche aufweist, die als Ansaugfläche für das Ansaugwerkzeug eines Bestückautomaten geeignet ist.
